# EUROPÄISCHE PATENTSCHRIFT

(11) **EP 2 350 344 B1**
(45) Veröffentlichungstag und Bekanntmachung des Hinweises auf die Patenterteilung: **12.12.2012**
(21) Anmeldenummer: 09751778.3
(22) Anmeldetag: 09.10.2009
(51) Int. Cl.: C23C 28/00, C23C 14/34

(54) **VERFAHREN UND VORRICHTUNG ZUM AUFBRINGEN ODER EINBETTEN VON PARTIKELN AUF ODER IN EINE DURCH PLASMABESCHICHTUNG AUFGEBRACHTE SCHICHT**
METHOD AND DEVICE FOR APPLYING OR EMBEDDING PARTICLES TO/IN A LAYER APPLIED BY PLASMA COATING
PROCÉDÉ ET DISPOSITIF D'APPLICATION OU D'INSERTION DE PARTICULES SUR OU DANS UNE COUCHE APPLIQUÉE PAR REVÊTEMENT PLASMA

(30) Priorität: 30.10.2008 DE 102008055648; 08.05.2009 DE 102009021056
(43) Veröffentlichungstag der Anmeldung: 03.08.2011
(73) Patentinhaber: Bam, 12205 Berlin (DE)
(72) Erfinder: BECK, Uwe, 14612 Falkensee (DE)
(74) Vertreter: Zimmermann & Partner
(86) Internationale Anmeldenummer: PCT/EP2009/007384
(87) Internationale Veröffentlichungsnummer: WO 2010/049064

(56) Entgegenhaltungen:
- JP-A- 9 268 379
- US-A- 4 801 435
- KERSTEN H ET AL: "Surface modification of powder particles by plasma deposition of thin metallic films" SURFACE AND COATINGS TECHNOLOGY, Bd. 108-109, Nr. 1-3, 10. Oktober 1998 (1998-10-10), Seiten 507-512, XP002561655 ELSEVIER [CH] ISSN: 0257-8972
- KERSTEN H ET AL: "Plasma-powder interaction: trends in applications and diagnostics" INTERNATIONAL JOURNAL OF MASS SPECTROMETRY, Bd. 223-224, 15. Januar 2003 (2003-01-15), Seiten 313-325, XP004397005 ELSEVIER SCIENCE PUBLISHERS, AMSTERDAM [NL] ISSN: 1387-3806

## Beschreibung

Die Erfindung betrifft ein Verfahren nach dem Oberbegriff des Anspruchs 1 sowie eine Vorrichtung zur Durchführung dieses Verfahrens gemäß Anspruch 12.

Bei elektrochemisch abgeschiedenen Schichten (z. B. Ni-Dispersionsschichten) ist schon seit längerem die Einbringung von Fremdpartikeln zur Erzielung gewünschter Eigenschaften bekannt. Auch für Lacke oder Sol-Gel-Schichten, die ebenfalls aus der flüssigen Phase abgeschieden werden, sind Partikeleinbettungen für ad-on-Eigenschaften oder Änderungen der Oberflächentopographie bekannt. Bestimmte Beschichtungstechniken aus der flüssigen Phase (SAMs oder selfassembling monolayers) und LBL(layer-by-layer)-Techniken sind ebenfalls geeignet, partikuläre Oberflächenschichten zu erzeugen.

Für vakuumgestützte Plasmabeschichtungsverfahren gibt es derzeit jedoch keine kommerziellen Lösungen. Prinzipiell ist man mit Assist-Quellen, die sich außerhalb des Magnetrons oder Plasmatrons befinden, wie z. B. Hohlkathodenquellen oder Plasmajets, in der Lage, Partikel zu erzeugen und diese auch in Schichten einzubringen. Beide Quellen, d. h. die eigentliche Beschichtungsquelle, die die Schichtmatrix erzeugt, und die Assist-Quelle, müssen dann gleichzeitig auf das Substrat gerichtet sein, was zu geometrischen und plasmakorrelierten Problemen führt. Daher wurde eine derartige Beschichtung bisher nur in Versuchsanlagen erprobt, mit dem Ergebnis, dass Inhomogenitäten der modifizierten Schichten nicht zu vermeiden waren. Außerdem sind mit solchen Assist-Quellen nicht beliebige Partikel einbringbar, sondern nur solche, die sputterfähig, arcfähig oder plasmajetfähig sind. Unter Partikeln sind hierbei nur Cluster von Materialien oder Materialmischungen zu verstehen. Insgesamt führt die Kombination zweier Quellen jedoch nicht nur aus geometrischen, sondern auch aus elektrotechnischplasmatechnischen sowie steuerungstechnischen Gründen zu schwerwiegenden Problemen bei der praktischen Durchführung. Auch der Raumbedarf sowie die Kosten einer derartigen Beschichtungsanlage sind erheblich.

Die Druckschrift JP 09-268379 beschreibt die Herstellung eines Films oder eines gesinterten Presslings frei von oberflächlichen Rauheiten durch Sprühen feiner Keramik- oder Metallpartikel auf die Oberfläche eines Substrates sowie das Bewegen des Substrates und Besprühen des Anheftungsflecks der feinen Partikeln mit einem Hochtemperaturgas.

Die Publikation von H. Kersten et al. in Surface and Coatings Technology, Band 108-109, Seiten 507-512 beschreibt die Modifizierung der Oberfläche von Partikeln mit dünnen Metallfilmen in einem Plasma, wobei in den Plasmaraum injizierte Eisenpartikel mittels Magnetron-Sputtern mit einem dünnen Aluminiumfilm versehen werden.

Die Übersichtsarbeit von H. Kersten, H. Deutsch, E. Stoffels, W.W. Stoffels und G.M.W. Kroesen (2003) im International Journal of Mass Spectrometry 223-224: 313-325 beschreibt allgemein die Wechselwirkung von Plasma und Pulvern unter dem Blickwinkel von Trends in Anwendungen und Diagnostik.

Es ist daher die Aufgabe der vorliegenden Erfindung, ein Verfahren zum definierten Aufbringen oder Einbetten von Nano- oder Mikropartikeln mindestens einer beliebigen Substanz auf oder in eine durch Plasmabeschichtung auf eine Substratfläche aufzubringende Schicht vor dem, während des oder nach dem Plasmabeschichtungsvorgang in einem Magnetron oder Plasmatron anzugeben, das mit vergleichsweise geringem Aufwand eine weitgehend homogene Verteilung der Partikel auf oder in der Schichtmatrix ermöglicht, so dass die gewünschten Schichteigenschaften erhalten werden können. Hinsichtlich der Art der verwendeten Partikel sollen möglichst geringe Beschränkungen bestehen.

Diese Aufgabe wird erfindungsgemäß durch ein Verfahren mit den Merkmalen des Anspruchs 1 gelöst. Vorteilhafte Weiterbildungen dieses Verfahrens ergeben sich aus den Unteransprüchen 2 bis 9.

Eine Vorrichtung zur Durchführung des Verfahrens ist in Anspruch 12 definiert, mit bevorzugten Ausführungsformen gemäß den Ansprüchen 13 bis 16.

Dadurch, dass beliebige extern erzeugte oder modifizierte Partikel über mindestens eine Druckstufe von außen in die Vakuumkammer des Magnetrons oder Plasmatrons räumlich verteilt in den Plasmaraum zwischen Target und Substrat eingebracht werden, werden die Partikel nicht von einer räumlich konzentrierten Quelle gerichtet zugeführt, sondern sie können räumlich homogen verteilt in den Plasmaraum eingebracht und somit auch homogen verteilt auf dem Substrat abgeschieden.werden.

Die Partikel werden vorzugsweise unter Verwendung eines Spülgases wie Argon oder Stickstoff von außen, d. h. der Nichtvakuumseite des Magnetrons oder Plasmatrons, in den Plasmaraum zwischen dem Target und dem Substrat eingebracht. Die Zuführung erfolgt durch kleine Löcher oder Düsen, die linienförmig oder flächig so verteilt sind, dass sich eine möglichst homogen verteilte Einbringung ergibt. Dabei erfolgt die Zuführung bevorzugt in einem Targetbereich, in welchem das Target nicht oder wenig abgetragen wird, d. h. außerhalb der primären Targeterosionszone. In dem Plasmaraum sind die Partikel dem elektrischen Feld des Plasmaraums oder einem statischen oder dynamischen elektrischen Wechselfeld ausgesetzt. Durch eine der Druckstufe folgende Ladungsübertragungseinheit werden elektrische Oberflächenladungen beispielsweise durch eine Elektronendusche, Reibungselektrizität oder dergleichen auf den Partikeln gebildet. Diese so aufgeladenen Partikel haben einerseits eine deutlich geringere Tendenz zur Agglomeration als ungeladene Partikel und können andererseits, weil sie elektrisch negativ aufgeladen sind, durch das elektrische Feld vom Target (negatives Potential) weg zum Substrat (positives Potential) hin beschleunigt werden. Für Partikelmaterialien wie Metalle, die selbst leitfähig sind und sich nicht oder nur schwer aufladen lassen, können die Partikel mit nichtleitenden Überzügen, die ggf. auch die Plasmabeständigkeit der Partikel sicherstellen, wie z. B. solchen aus SiO₂, versehen werden. Andererseits besteht auch die Möglichkeit, bereits geladene Partikel durch die Ladungsübertragungseinheit elektrisch zu neutralisieren und in ungeladenem Zustand in die Vakuumkammer einzubringen.

Durch das erfindungsgemäße Verfahren können somit extern erzeugte Nano- oder Mikropartikel in Form von Pulvern oder Feingranulaten über zumindest eine Druckstufe oder ggf. unter Anwendung einer Ladungsübertragungseinheit vorzugsweise in den Bereich außerhalb der Targeterosionszone als geladene oder ungeladene Spezies in die Vakuumkammer eines Magnetrons oder Plasmatrons eingebracht werden und aus diesem in den Plasmaraum zwischen Target und Substrat emittiert und fein verteilt auf das Substrat aufgebracht werden. Dies kann entweder während, vor oder nach einem Plasmabeschichtungsvorgang erfolgen, d. h. sowohl in Anwesenheit als auch in Abwesenheit eines Plasmas. Die Partikel können somit in die Matrix des plasmabeschichteten Materials eingebettet sein oder eine eigene Schicht unter oder über der Matrix bilden. Auch Schichten zwischen einzelnen Matrixschichten sind möglich. Die Partikelinjektion erfolgt dabei typischerweise nur kurzzeitig in Form eines Einzelimpulses oder einer Abfolge von Impulsen.

Durch die zugeführten Partikel können die Schichteigenschaften in vielfältiger Weise beeinflusst werden. Die Anwendungsbreite reicht von Marker-Partikeln bis hin zu Funktionspartikeln wie Trockenschmierung, Farbpigmenten, Reservoirbildung, topographische Funktion, Fluoreszenz und dergleichen.

Die Erfindung wird im Folgenden anhand eines in den Figuren dargestellten Ausführungsbeispiels näher erläutert. Es zeigen:
- Fig. 1: eine Plasmabeschichtungsanlage in schematischer Querschnittsdarstellung, und
- Fig. 2: die Unterseite des in Fig. 1 gezeigten Targets.

In einer Vakuumprozesskammer 1 befinden sich ein zu beschichtendes Substrat 2 sowie dessen zu beschichtender Oberfläche gegenüberliegend ein Target 3. Auf der dem Substrat 2 abgewandten Seite ist das Target 3 mit einem Magnetron oder Plasmatron 4 zur Erzeugung der für die Ausbildung eines Plasmas 5 zwischen Substrat 2 und Target 3 benötigten Energie verbunden.

In der Vakuumprozesskammer 2 wird ein Prozessdruckvon typischerweise 0,1 Pa (10⁻³ mbar) aufrechterhalten. Hierfür wird vorzugsweise Argon verwendet, das zusammen mit einem Reaktionsgas für die Aufbringung der Beschichtung das Prozessplasma 5 bildet.

Diese insoweit bekannte Plasmabeschichtungsanlage wird erfindungsgemäß durch eine spezielle Vorrichtung zum Einbringen von Partikeln in die Vakuumprozesskammer 1 ergänzt. Diese Vorrichtung besteht im Wesentlichen aus einem Vorratsbehälter 6 für die Partikel, einem Transportrohr 7 für die Beförderung der Partikel aus dem Vorratsbehälter 6, einem an dieses angeschlossene Rohrverzweigungssystem aus einer Vielzahl paralleler Rohre 8, die durch das Magnetron oder Plasmatron 4 und das Target 3 hindurchgeführt sind und jeweils in einer Düse 9 auf der Unterseite des Targets 3 münden, mindestens zwei piezoelektrisch betätigbaren Ventilen 10, die im Verlauf des Transportrohres 7 hintereinander angeordnet sind, sowie gegebenenfalls einer nicht dargestellten Ladungsübertragungseinheit, die an einer geeigneten Stelle in dem Weg der Partikel zwischen dem Vorratsbehälter 6 und dem Eintritt der Rohre 8 in das Magnetron oder Plasmatron 4 vorgesehen sein kann.

Die Ventile 10 dienen zur Aufrechterhaltung des Druckunterschieds zwischen dem Vorratsbehälter 6, dessen Inneres vorzugsweise auf Atmosphärendruck gehalten wird, und der Vakuumprozesskammer 1. Zur Erhöhung der Betriebssicherheit können auch mehr als zwei derartige Ventile verwendet werden. Die Partikel können im Vorratsbehälter als Pulver bzw. Staub, in Flüssigkeiten oder Dämpfen dispergiert oder in Form von Aerosolen aufgenommen sein. Sie können in elektrisch geladenem oder ungeladenem Zustand vorliegen.

Die Ventile 10 werden so gesteuert, dass die Partikel durch den Druckunterschied in einem Transportmedium jeweils stoßweise aus dem Vorratsbehälter 6 in die Vakuumprozesskammer 1 bzw. das Prozessplasma 5 injiziert werden. Sie treten in divergierenden Strahlen 11 aus den jeweiligen Düsen 9 aus. Dabei verteilen sie sich gleichmäßig im Raum zwischen dem Substrat 2 und dem Target 3 und werden auf dem Substrat 2 abgeschieden. Dieser Vorgang wird beschleunigt, wenn die Partikel negativ geladen sind, da sie dann von dem gegenüber dem Target 3 auf positivem Potential liegenden Substrat 2 angezogen werden.

Als Transportmedium wird vorzugsweise ein Spülgas ein gegebenenfalls ionisiertes Edelgas wie Argon oder ein gegebenenfalls ionisiertes Reaktionsgas wie Sauerstoff, Stickstoff oder ein Alkan, Alken oder Elkin verwendet.

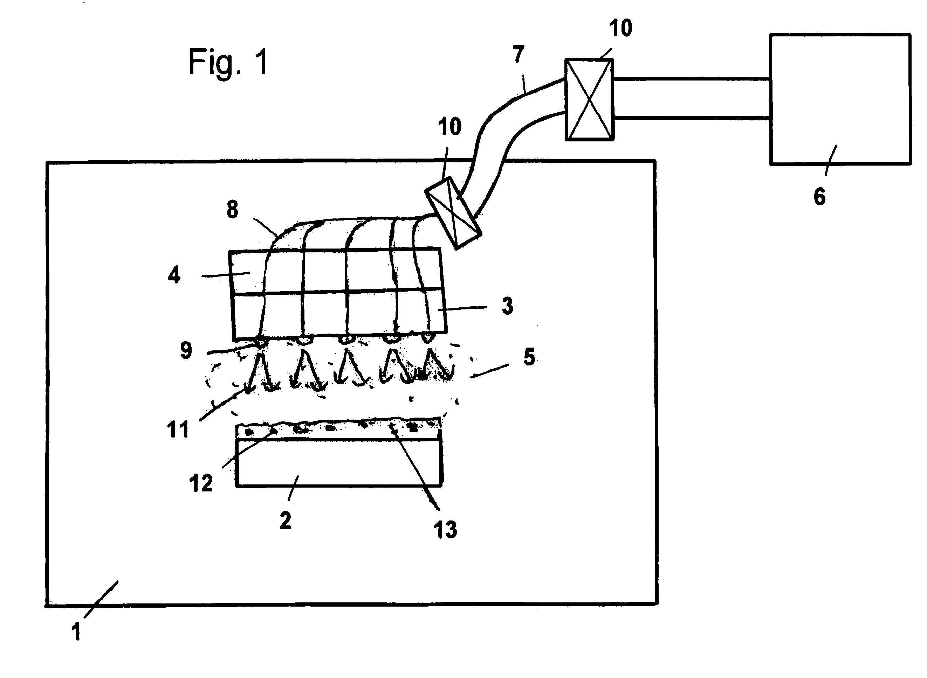

Die Zuführung der Partikel zu der Vakuumprozesskammer 1 kann auch dann erfolgen, wenn kein Plasma 5 in dieser gebildet ist. Dies kann vor oder nach dem Plasmabeschichtungsvorgang erfolgen, so dass es möglich ist, die Partikel nicht nur während des Plasmabeschichtungsvorgangs in die sich bildende Schicht einzubetten, sondern auch eine eigenständige Partikelschicht unter und/oder auf dieser Schicht zu erzeugen. In dem in Fig. 1 dargestellten Beispiel sind die Partikel 12 in die aufgebrachte Schicht 13 eingebettet.

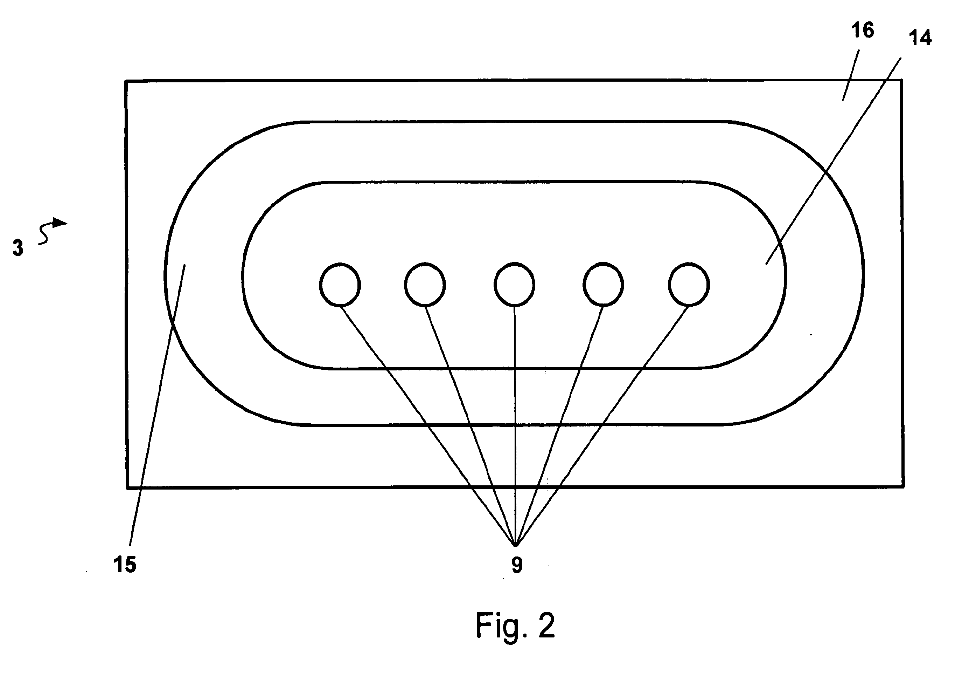

Zur Bildung der Schicht 13 wird Material des Targets 3 durch Einwirkung des Prozessplasmas 5 abgetragen und reagiert mit dem im Plasma 5 vorhandenen Reaktivgas, wodurch eine Verbindung entsteht, die sich auf dem Substrat 2 als die Schicht 13 niederschlägt. Über die Düsen 9 in das Plasma 5 eingebrachte Partikel werden ebenfalls abgeschieden, so dass diese gleichmäßig verteilt in die Schicht 13 eingebettet sind. Fig. 2 zeigt die Unteransicht des Targets 3. Die Düsen 9 sind in gleichen gegenseitigen Abständen entlang der Längsmittelachse der Targetfläche angeordnet. Sie befinden sich in einem Bereich 14 dieser Fläche, in welchem das Targetmaterial nicht oder in nur geringem Maß abgetragen wird. In einem den Bereich 14 umgebenden ovalen Bereich 15 ("raise track") hingegen findet eine starke Materialabtragung durch Beschuss positiver Ionen aus dem Prozessplasma 5 statt. In einem Randbereich 16 der Targetoberfläche wiederum ist die Materialabtragung minimal. Durch die dargestellte Anordnung der Düsen 9 wird verhindert, dass diese durch den Ionenbeschuss beschädigt oder zerstört werden, und dennoch ermöglicht, dass sich die Partikel gleichmäßig im Plasma ausbreiten.

Je nach Anwendungsfall kann es sinnvoll sein, dass die Partikel geladen oder elektrisch neutral in das Plasma eingebracht werden. Haben die im Vorratsbehälter 6 befindlichen Partikel nicht bereits den gewünschten Ladungszustand, so müssen sie auf ihrem Weg in die Vakuumprozesskammer 1 durch die Ladungsübertragungseinheit, z.B. eine Elektronendusche, in diesen gebracht werden. Bestehen die Partikel aus Metall, dann müssen sie zumindest dann, wenn sie eine bestimmte Ladung tragen sollen, vorher mit einem isolierenden Überzug versehen werden.

Werden elektrisch neutrale Partikel in das Plasma eingebracht, so besteht nicht die Möglichkeit, sie durch ein elektrisches Feld zum Substrat hin zu beschleunigen. die Druckdifferenz zwischen der letzten Druckstufe und der Vakuumprozesskammer 1 muss dann ausreichend sein, um den Partikeln beim Eintreten in diese eine solche Geschwindigkeit zu verleihen, dass sie bis zum Substrat gelangen können.

## Patentansprüche

1. Verfahren zum definierten Aufbringen oder Einbetten von Nano- oder Mikropartikeln mindestens einer beliebigen Substanz auf oder in eine durch Plasmabeschichtung auf eine Oberfläche eines Substrates (2) durch Abtragung von Material eines Targets (3) aufgebrachte Schicht (13) vor dem, während des oder nach dem Plasmabeschichtungsvorgang in einem Magnetron oder Plasmatron (4) **dadurch gekennzeichnet , dass** beliebige extern erzeugte oder modifizierte Partikel über mindestens eine Druckstufe (10) von außen in die Vakuumkammer (1) des Magnetrons oder Plasmatrons (4) räumlich verteilt in den Plasmaraum (5) zwischen das Target (3) und das Substrat (2) eingebracht werden.

2. Verfahren nach Anspruch 1, **dadurch gekennzeichnet, dass** die Partikel in dem Plasmaraum (5) einem eine zum Substrat (2) hin gerichtete Bewegung erzeugenden elektrischen Feld ausgesetzt werden.

3. Verfahren nach Anspruch 2, **dadurch gekennzeichnet, dass** die Partikel vor dem Einbringen in den Plasmaraum (5) elektrisch geladen werden.

4. Verfahren nach Anspruch 3, **dadurch gekennzeichnet, dass** Partikel aus elektrisch leitendem Material vor der Aufladung mit einem Überzug aus nichtleitendem Material versehen werden.

5. Verfahren nach Anspruch 1, **dadurch gekennzeichnet, dass** die Partikel elektrisch neutral sind oder vor dem Einbringen in die Vakuumkammer (1) elektrisch neutralisiert werden.

6. Verfahren nach einem der Ansprüche 1 bis 5, **dadurch gekennzeichnet, dass** die Partikel durch kleine Löcher oder Düsen (9) in den Plasmaraum (5) eingebracht werden.

7. Verfahren nach Anspruch 6, **dadurch gekennzeichnet, dass** die Löcher oder Düsen (9) linienförmig oder flächig verteilt angeordnet sind.

8. Verfahren nach einem der Ansprüche 1 bis 7, **dadurch gekennzeichnet, dass** die Partikel in einen Bereich des Plasmaraums (5) eingebracht werden, in welchem nur eine geringe oder keine Abtragung des Targets (3) erfolgt.

9. Verfahren nach einem der Ansprüche 1 bis 8, **dadurch gekennzeichnet, dass** die Partikel mit Hilfe eines Spülgases in den Plasmaraum (5) eingebracht werden.

10. Verfahren nach Anspruch 9, **dadurch gekennzeichnet, dass** als Spülgas ein gegebenenfalls ionisiertes Edelgas, vorzugsweise Argon oder ein gegebenenfalls ionisiertes Reaktivgas, vorzugsweise Sauerstoff, Stickstoff oder ein Alkan, Alken oder Alkin verwendet wird.

11. Verfahren nach einem der Ansprüche 1 bis 10, **dadurch gekennzeichnet, dass** die Einbringung der Partikel impulsweise erfolgt.

12. Vorrichtung zur Durchführung des Verfahrens nach einem der Ansprüche 1 bis 11, **dadurch gekennzeichnet, dass** in einer Vakuumprozesskammer (1) einander gegenüberliegend eine zu beschichtende Oberfläche des Substrats (2) und eine abzutragende Oberfläche des Targets (3) vorgesehen sind und in einem von der Abtragung zumindest weitgehend ausgenommenen Bereich (14) dieser Targetoberfläche Düsen (9) für die Injektion der Partikel möglichst gleichmäßig verteilt angeordnet sind.

13. Vorrichtung nach Anspruch 12, **dadurch gekennzeichnet, dass** für den Transport der Partikel von einem externen Vorratsbehälter (6) zu den Düsen (9) ein an den Vorratsbehälter (6) angeschlossenes Transportrohr (7) und ein diesem nachfolgendes Rohrverzweigungssystem aus mehreren, jeweils einer der Düsen (9) zugeordneten Rohren (8) vorgesehen sind.

14. Vorrichtung nach Anspruch 13, **dadurch gekennzeichnet, dass** die Rohre (8) des Rohrverzweigungssystems jeweils durch das Magnetron oder Plasmatron (4) und das Target (3) hindurch zu der zugeordneten Düse (9) geführt sind.

15. Vorrichtung nach Anspruch 13 oder 14, **dadurch gekennzeichnet, dass** in dem Transportrohr (7) nacheinander mindestens zwei als Druckstufen dienende piezoelektrisch betätigbare Ventile (10) vorgesehen sind.

16. Vorrichtung nach einem der Ansprüche 13 bis 15, **dadurch gekennzeichnet, dass** in dem Transportrohr (7) eine Ladungsübertragungseinheit zur Aufladung ungeladener Partikel oder zur Ladungsneutralisation geladener Partikel vorgesehen ist.

## Claims

1. A method for the defined application or embedding of nano- or microparticles of at least one arbitrary substance onto or into a layer (13) applied by means of plasma coating onto a surface of a substrate (2) by removing material of a target (3) before, during or after the plasma coating process in a magnetron or plasmatron (4), **characterised in that** arbitrary externally created or modified particles are introduced by means of at least one pressure stage (10) from outside into the vacuum chamber (1) of the magnetron or plasmatron (4) in a spatially distributed manner into the plasma space (5) between the target (3) and the substrate (2).

2. The method according to Claim 1, **characterised in that** the particles in the plasma space (5) are subjected to an electrical field generating a movement directed towards the substrate (2).

3. The method according to Claim 2, **characterised in that** the particles are electrically charged before introduction into the plasma space (5).

4. The method according to Claim 3, **characterised in that** particles made of electrically-conductive material are provided with a coating layer made up of nonconductive material before charging.

5. The method according to Claim 1, **characterised in that** the particles are electrically neutral or are electrically neutralised before introduction into the vacuum chamber (1).

6. The method according to one of Claims 1 to 5, **characterised in that** the particles are introduced by means of small holes or nozzles (9) into the plasma space (5).

7. The method according to Claim 6, **characterised in that** the holes or nozzles (9) are arranged distributed in a line or over an area.

8. The method according to one of Claims 1 to 7, **characterised in that** the particles are introduced into a region of the plasma space (5), in which only a small or no removal of the target (3) takes place.

9. The method according to one of Claims 1 to 8, **characterised in that** the particles are introduced into the plasma space (5) with the aid of a flushing gas.

10. The method according to Claim 9, **characterised in that** an if appropriate ionised noble gas, preferably argon, or an if appropriate ionised reactive gas, preferably oxygen, nitrogen or an alkane, alkene or alkyne is used as flushing gas.

11. The method according to one of Claims 1 to 10, **characterised in that** the introduction of the particles takes place in a pulsed manner.

12. A device for carrying out the method according to one of Claims 1 to 11, **characterised in that** a surface of the substrate (2) to be coated and a surface of the target (3) to be removed are provided opposite one another in a vacuum process chamber (1) and nozzles (9) for the injection of the particles are arranged in as evenly distributed a manner as possible in a region (14) which is at least substantially excepted from the removal.

13. The device according to Claim 12, **characterised in that** for transporting the particles from an external storage container (6) to the nozzles (9), a transporting pipe (7) attached to the storage container (6) and a pipe manifold system following the transporting pipe, made up of a plurality of pipes (8) in each case assigned to one of the nozzles (9), are provided.

14. The device according to Claim 13, **characterised in that** the pipes (8) of the pipe manifold system are in each case guided through the magnetron or plasmatron (4) and the target (3) to the assigned nozzle (9).

15. The device according to Claim 13 or 14, **characterised in that** at least two piezoelectrically actuatable valves (10), which are used as pressure stages, are provided one after the other in the transporting pipe (7).

16. The device according to one of Claims 13 to 15, **characterised in that** the charge transfer unit for charging uncharged particles or for charge neutralisation of charged particles is provided in the transporting pipe (7).

## Revendications

1. Procédé pour application ou inclusion définie de nano- ou microparticules au moins d'une substance quelconque sur ou dans une couche (13) appliquée par enlèvement de matière d'une cible (3) sur une surface d'un substrat (2) par revêtement de plasma, avant, pendant ou après l'opération de revêtement de plasma dans un magnétron ou plasmatron (4) **caractérisé en ce que** des particules quelconques produites ou modifiées extérieurement sont introduites depuis l'extérieur dans la chambre à vide (1) du magnétron ou plasmatron (4) sur au moins un étage de pression (10), réparties dans l'espace dans l'espace de plasma (5) entre la cible (3) et le substrat (2).

2. Procédé selon la revendication 1 **caractérisé en ce que** les particules dans l'espace de plasma (5) sont exposées à un champ électrique produisant un mouvement orienté vers le substrat (2).

3. Procédé selon la revendication 2 **caractérisé en ce que** les particules sont chargées électriquement avant l'introduction dans l'espace de plasma (5).

4. Procédé selon la revendication 3 **caractérisé en ce que** les particules d'un matériau électroconducteur sont dotées avant la charge d'un revêtement en matériau non conducteur.

5. Procédé selon la revendication 1 **caractérisé en ce que** les particules sont électriquement neutres ou sont électriquement neutralisées avant l'introduction dans la chambre à vide (1).

6. Procédé selon une des revendications 1 à 5 **caractérisé en ce que** les particules sont introduites dans l'espace de plasma (5) par de petits trous ou buses (9).

7. Procédé selon la revendication 6 **caractérisé en ce que** les trous ou buses (9) sont disposés de façon répartie, en ligne ou en nappe.

8. Procédé selon une des revendications 1 à 7 **caractérisé en ce que** les particules sont introduites dans une zone de l'espace de plasma (5) dans laquelle n'a lieu qu'un faible enlèvement faible ou pas d'enlèvement de la cible (3).

9. Procédé selon une des revendications 1 à 8 **caractérisé en ce que** les particules sont introduites dans l'espace de plasma (5) à l'aide d'un gaz d'entraînement.

10. Procédé selon la revendication 9 **caractérisé en ce que** comme gaz d'entraînement on utilise un gaz noble, le cas échéant ionisé, de préférence de l'argon ou un gaz réactif, le cas échéant ionisé, de préférence de l'oxygène, de l'azote, ou un alcane, alcène ou alcyne.

11. Procédé selon une des revendications 1 à 10 **caractérisé en ce que** l'introduction des particules a lieu par impulsion.

12. Dispositif pour exécuter le procédé selon une des revendications 1 à 11 **caractérisé en ce que** dans une chambre de traitement à vide (1) sont prévues, situées l'une à côté de l'autre, une surface de substrat (2) à revêtir et une surface de cible (3) à enlever et **en ce que** dans une zone (14) de cette surface de cible (9) pour le moins largement vidée par l'enlèvement, sont disposées des buses (9) pour l'injection des particules, réparties le plus uniformément possible.

13. Procédé selon la revendication 12 **caractérisé en ce que** pour le transport des particules d'un conteneur de réserve (6) extérieur vers les buses (9) sont prévus un conduit de transport (7) raccordé au conteneur de réserve (6) et un système de tubulure faisant suite à celui-ci composé de plusieurs conduits (8) respectivement attribués à une des buses (9).

14. Procédé selon la revendication 13 **caractérisé en ce que** les conduits (8) du système de tubulure sont respectivement guidés à travers le magnétron ou plasmatron (4) et la cible (3) vers les buses (9) attribuées.

15. Procédé selon une des revendications 13 ou 14 **caractérisé en ce que** dans le conduit de transport (7) sont prévues l'une après l'autre au moins deux vannes (10) à commande piézoélectrique servant d'étages de pression.

16. Procédé selon une des revendications 13 à 15 **caractérisé en ce que** dans le conduit de transport (7) est prévue une unité de transfert de charge pour charger des particules non chargées ou pour neutraliser la charge de particules chargées.
